# EUROPÄISCHE PATENTSCHRIFT

(11) **EP 1 598 456 B1**
(45) Veröffentlichungstag und Bekanntmachung des Hinweises auf die Patenterteilung: **12.11.2008**
(21) Anmeldenummer: 05008121.5
(22) Anmeldetag: 14.04.2005
(51) Int. Cl.: D01H 7/60, C23C 16/36

(54) **Ringläufer und Verfahren zu dessen Herstellung**
Ring traveller and method for producing the same.
Curseur et son procédé de production

(30) Priorität: 17.05.2004 CH 8642004
(43) Veröffentlichungstag der Anmeldung: 23.11.2005
(73) Patentinhaber: Bräcker AG, 8330 Pfäffikon (CH)
(72) Erfinder: Kägi, Jörg, 8498 Gibswil (CH)
(74) Vertreter: Schaad, Balass, Menzl & Partner AG

(56) Entgegenhaltungen:
- EP-A- 1 207 216
- DE-A- 3 545 484
- DE-A- 3 839 920
- US-A- 5 302 422
- PATENT ABSTRACTS OF JAPAN Bd. 0092, Nr. 41 (C-306), 27. September 1985 (1985-09-27) & JP 60 099024 A (KANAI JIYUUYOU KOGYO KK; others: 01), 1. Juni 1985 (1985-06-01)
- DATABASE WPI Section Ch, Week 198608 Derwent Publications Ltd., London, GB; Class F01, AN 1986-052473 XP002292262 & JP 61 006329 A (KANAI H) 13. Januar 1986 (1986-01-13)
- PATENT ABSTRACTS OF JAPAN Bd. 0112, Nr. 06 (C-433), 3. Juli 1987 (1987-07-03) & JP 62 028418 A (NIPPON SPINDLE MFG CO LTD), 6. Februar 1987 (1987-02-06)

## Beschreibung

Die Erfindung betrifft einen Ringläufer für Ringspinn- oder Ringzwirnmaschinen sowie ein Verfahren zu dessen Herstellung.

Ringläufer von Ringspinn- und Ringzwirnmaschinen werden mit hoher Geschwindigkeit (30 m/Sek. bis 50 m/Sek.) auf Ringen der entsprechenden Ringspinn- oder Ringzwirnmaschinen bewegt. Sowohl die Kontaktfläche zwischen Ringläufer und Ring als auch die Kontaktfläche zwischen Ringläufer und Faden sind einem hohen Verschleiss unterworfen. Zur Produktionssteigerung werden jedoch zunehmend höhere Laufgeschwindigkeiten der Ringläufer gefordert. Durch Erreichen höherer Standzeiten sollten gleichzeitig die Kosten gesenkt werden.

Durch Beschichtung der Ringläufer mit entsprechenden Materialien, konnten deren Lauf- und Betriebseigenschaften in den letzten Jahren deutlich verbessert werden. Die Verschleissfestigkeit sowohl am Fadendurchgang wie an der Ringkontaktfläche konnte bei Läufergeschwindigkeiten über 40 m /sec. jedoch nicht ausreichend verbessert werden.

In DE 35 45 484 wird ein Ringläufer für eine Spinnmaschine beschrieben, der eine keramische Überzugsschicht trägt, die mindestens den Oberflächenbereich abdeckt, der mit dem Ring in Berührung kommt. Die keramische Überzugsschicht besteht aus einer oder mehreren Schichten, ausgewählt aus einer Carbidschicht wie SiC, TiC, ZrC, einer Nitridschicht wie etwa TiN, TiCN, ZrN, einer Oxidschicht wie Al₂O₃, ZrO₃, SiO₂ oder einer Boridschicht wie TiB₂ und ZrB₂. Die Keramikschichten werden durch das CVD- oder durch das PVD-Verfahren auf den Kern aufgebracht. Anschliessend werden die beschichteten Ringläufer abgeschreckt und geschliffen. Die Titancarbidschichten und Titannitridschichten weisen eine Härte von 1900 bis 2500 HV auf.

In CH 487 535 wird ein Ringläufer für Spinn- und Zwirnmaschen beschrieben, wobei der Ring und/oder der Läufer mit einer Beschichtung aus Titanaluminiumnitrid beschichtet ist.

CH 589 723 beschreibt ein Verfahren zum Beschichten von anorganischen Substraten mit Carbiden, Nitriden oder Carbonitriden.

Aufgabe der vorliegenden Erfindung ist es, einen Ringläufer für Ringspinn- oder Ringzwirnmaschinen zu schaffen, der weiter verbesserte Lauf- und Betriebseigenschaften aufweist. Ferner ist ein Verfahren zur Herstellung dieses Ringläufers anzugeben.

Die Aufgabe wird gelöst durch einen Ringläufer, welcher die in Anspruch 1 angegebenen Merkmale aufweist, beziehungsweise durch ein Verfahren gemäss Anspruch 11. Weitere bevorzugte Ausführungsformen sind Gegenstand der abhängigen Ansprüche.

Ein erfindungsgemässer Ringläufer weist einen Kern aus einem Eisenwerkstoff auf, der zumindest im Bereich der Laufflächen, mit denen er auf einem Ring einer Ringspinn- oder Ringzwirnmaschine gleitet oder in denen der Faden geführt ist, eine Deckschicht aufweist. Die Deckschicht enthält feinkristallines TiCN (Titancarbonitrid), CrN (Chromnitrid) oder VC (Vanadiumcarbid).

Die feinkristalline Form der Deckschicht hat zur Folge, dass die Eigenspannung der Deckschicht kleiner wird. Dadurch entstehen keine Mikrorisse. Bei der Entstehung von Mikrorissen besteht immer die Gefahr der Abplatzung der Deckschichten insbesondere beim Aufsetzen des Ringläufers, was zwangsläufig zum Auswechseln dieser Ringläufer führen muss. Daher haben die erfindungsgemässen Ringläufer eine stark verbesserte Verschleissfestigkeit am Fadendurchgang und an der Ringanlage. Die Verschleissrate gegenüber Ringläufern mit einer herkömmlichen Keramikschicht, galvanischen Beschichtung oder Nickeldispersionsbeschichtung sinkt um ca. 80% und die Lebensdauer eines Ringläufers wird 3 bis 10 mal, das heisst auf 500 - 1500 Betriebsstunden, verlängert. Dadurch sinken die Betriebskosten signifikant. Durch die Deckschicht hat der erfindungsgemässe Ringläufer eine gute Abriebfestigkeit und Korrosionsfestigkeit.

In einer bevorzugten Ausführungsform enthält die Deckschicht feinkristallines TiCN, besonders bevorzugt reines feinkristallines TiCN, das eine Härte von HV 0.025 von 2600 bis 3600 aufweist. TiCN ist hart und gleichzeitig relativ zäh, was es besonders geeignet als Deckschicht des erfindungsgemässen Ringläufers macht.

In einer bevorzugten Ausführungsform wird zwischen der Deckschicht und dem Kern eine Zwischenschicht als Haftverbesserung aufgebracht, die TiN enthält. Es wäre auch möglich an Stelle von TiN andere Metallnitride zu verwenden, wie zum Beispiel CrN. Die Titannitridschicht weist eine ausgesprochen gute Affinität zum Eisenwerkstoff auf, was langfristig die Stabilität des Ringläufers erhöht. So kann beispielsweise Materialabplatzungen vorgebeugt werden. Die Zwischenschicht kann ein- oder mehrlagig sein. Die Deckschicht aus feinkristallinem Titancarbonitrid, Chromnitrid oder Vanadiumcarbid lässt sich problemlos auf der Titannitrid enthaltenden Zwischenschicht aufbringen.

Die Deckschicht des erfindungsgemässen Ringläufers kann ein- oder mehrlagig sein. In einer bevorzugten Ausführungsform ist sie mehrlagig. Die Deckschicht weist eine Dicke von 0.1 bis 20 µm, vorzugsweise von 4 bis 10 µm auf. Je dicker die Deckschicht ist, umso verschleissfester ist der Ringläufer.

In einer besonders bevorzugten Ausführungsform ist die Deckschicht vollflächig auf dem Kern beziehungsweise auf der Zwischenschicht aufgebracht.

Der Eisenwerkstoff des Ringläufers kann jede beliebige Stahlform sein, besonders geeignet ist der Kern des Ringläufers jedoch aus einem unlegiertem Werkzeugstahl, Kaltarbeitsstahl, einem Federstahl oder einem Schnellstahl.

Der erfindungsgemässe Ringläufer wird hergestellt, in dem zumindest Teile des Kerns mit einer Deckschicht überzogen werden. Dabei wird in einem ersten Schritt der Kern in einer Reaktionskammer auf 700° bis 1200°C erhitzt. Anschliessend wird in eine Reaktionskammer ein Abscheidungsgas eingeleitet, so dass auf der Oberfläche des Kerns eine Schicht mit feinkristallinem Titancarbonitrid, Chromnitrid oder Vanadiumcarbid aufgetragen wird. Anschliessend wird der beschichtete Ringläufer unter Schutzgas während langsam abgekühlt. Das langsame Abkühlen des beschichteten Ringläufers unter Schutzgas stellt ein wesentlicher Verfahrensschritt dar, denn nur so kann sichergestellt werden, dass die erhaltene Deckschicht eine kristallisierte Nadelstruktur aufweist, d.h. feinkristallin ist, und damit eine sehr kleine Eigenspannung aufweist.

In einer bevorzugten Ausführungsform wird der abgekühlte Ringläufer nachgehärtet, in dem die Härtetemparatur dem Kernkohlenstoff angepasst wird, beispielsweise bei 840°C und für 30 Minuten gehalten wird.

In einer weiteren bevorzugten Ausführungsform wird der nachgehärtete Ringläufer in einem Thermalbad (80°C warmem Ö1 oder einem Warmbad bei 170 - 260°C) abgeschreckt und bei 200 bis 350°C während 0.5 bis 1.5 Stunden angelassen, das heisst, einer Wärmebehandlung unterzogen. Dadurch erhält der Ringläufer eine grössere Zähigkeit und Elastizität, was eine längere Betriebsdauer des Ringläufers gewährleistet und sich sehr günstig auf die Schichthaftung auswirkt.

In einer bevorzugten Ausgestaltung der Erfindung wird die Oberfläche des Ringläufers vor und/oder nach der Beschichtung zusätzlich poliert, sodass eine fadenfeine Oberfläche erhalten wird. Als Poliermittel eignen sich z.B. diamanthaltige Pasten oder Schleifmittel welche über der Härte der Deckschicht liegen.

Idealerweise wird der Kern vor der Beschichtung entfettet.

Die erfindungsgemässen Ringläufer können sowohl in Spinnereinen als auch in Zwirnereien verwendet werden. Ihre guten Laufeigenschaften, wie zum Beispiel gutes Gleiten und geringer Verschleiss, kommen besonders vorteilhaft im Zusammenwirken mit beschichteten Stahlringen zur Geltung, sie können aber auch auf anderen Ringen, wie zum Beispiel auf gesinterten oder unbeschichteten Ringen verwendet werden.

Die erfindungsgemässen Ringläufer mit einer feinkristallinen Titancarbonitrid-Deckschicht können universell eingesetzte werden, sie sind aber insbesondere geeignet für Ringläufer, die relativ hohen Kräften ausgesetzt sind oder wenn eine Mangelschmierung vorliegt.

Die erfindungsgemässen Ringläufer mit einer feinkristallinen Vanadiumcarbid-Deckschicht können ebenfalls universell eingesetzt werden, sind jedoch besonders bevorzugt, falls mit einer sehr hohen Laufgeschwindigkeit gearbeitet wird, da die feinkristalline Vanadiumcarbid Deckschicht ausgesprochen hart ist, d.h. eine Härte von 3000 - 4000 HV aufweist. Grundsätzlich ist hier auch der Einsatz einer grobkörnigen Vanadiumcarbid-Deckschicht denkbar.

Die erfindungsgemässen Ringläufer mit einer feinkristallinen Chromnitrid-Deckschicht können ebenfalls universell eingesetzt werden, sind jedoch besonders bevorzugt bei der Herstellung von Mischgarnen, da die Deckschicht sehr korrosionsresistent ist und bei der Herstellung von synthetischen Garnen, Avivagen und chlorhaltige Fasern zum Einsatz kommen, was die Korrosion natürlich erhöht. Grundsätzlich ist hier auch der Einsatz einer grobkörnigen Chromnitrid- Deckschicht denkbar.

Der erfindungsgemässe Ringläufer wird nachstehend anhand von in den Zeichnungen gezeigten Ausführungsbeispielen näher erläutert. Es zeigen rein schematisch
- Fig. 1a -1f: verschiedene Ausführungsformen von Ringläufern
- Fig. 2: den Schnitt durch den Kern eines Ringläufers vor dessen Bearbeitung
- Fig. 3: den Schnitt einer ersten Ausführungsform des erfindungsgemässen Ringläufers, bei dem die Deckschicht unmittelbar auf dem Kern aufgebracht ist
- Fig. 4: den Schnitt einer zweiten Ausführungsform des erfindungsgemässen Ringläufers, bei dem die Deckschicht auf einer zwischen Deckschicht und Kern angebrachten Zwischenschicht aufgebracht ist.

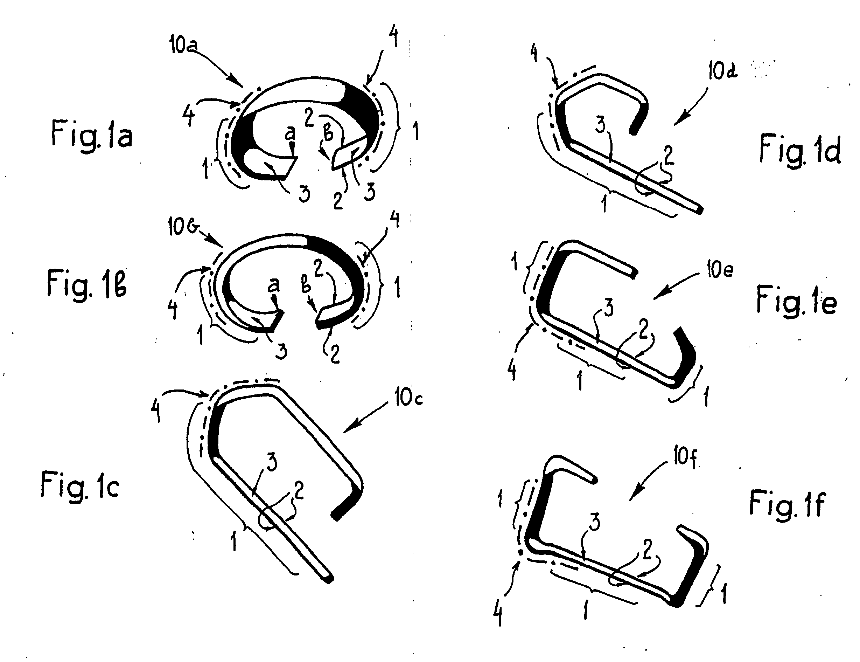

Die Figuren 1a bis 1f zeigen Ringläufer 10a, ..., 10f in verschiedenen Ausgestaltungen. In Fig. 1a und 1b sind C förmige Ringläufer 10a, 10b gezeigt, wie sie typischerweise auf T-Flanschringen von Ringspinn- oder Ringzwirnmaschinen eingesetzt werden. Die Figuren 1c bis 1f zeigen hingegen ohr- und hakenförmige Ringläufer 10c, .., 10f. Die Ringläufer 10c und 10d werden auf Schrägflanschringen, die Ringläufer 10e auf konisch verlaufenden und die Ringläufer 10f auf vertikal verlaufenden Flanschringen verwendet.

Mit 1 sind jeweils die Bereiche der Ringläufer 10a, ..., 10f gekennzeichnet, die während des Betriebes die auf den Flanschringen gleitenden Laufflächen bilden. Dabei können bei den C-förmigen Ringläufern 10a, 10b aufgrund ihrer symmetrischen Ausgestaltung beide Flanken a, b als Lauffläche dienen. Bei den ohr- oder schrägflansch und SU Ringläufern 10c, .., 10f ist der Bereich 1 der Laufflächen eindeutig durch die Form festgelegt.

Die erfindungsgemässe Ringläufer 10 bzw. 10a, .. 10f können in den in Fig. 1a, .. , 1f gezeigten oder in beliebigen weiteren Ausgestaltungen hergestellt werden.

Ein erfindungsgemässer Ringläufer 10 weist einen aus einem Eisenwerkstoff bestehenden, nicht beschichteten Kern 20 auf.' Auf dem Kern ist zumindest im Bereich 1 der Laufflächen, mit denen er auf einem Ring einer Ringspinn- oder Ringzwirnmaschine geführt wird, eine Deckschicht 24 aus feinkristallinem Chromnitrid, Vanadiumcarbid oder Titancarbonitrid angeordnet. Der Fadendurchgang liegt dabei in den mit 4 bezeichneten Bereichen der Ringläufer 10a, .. 10f.

Im Bereich des Lauffläche 1 muss vornehmlich eine mit 3 bezeichnete Innenseite des Ringläufers 10 verschleissfest und mit guten Gleiteigenschaften ausgestattet sein und daher eine Deckschicht aufweisen. Bei entsprechender Fadenspannung kann es sich ergeben, dass der Ringläufer seitlich verkippt auf einem Ring entlang läuft, so dass es sich als vorteilhaft erweisen kann, auch die beiden Stirnseiten 2 mit einer Deckschicht zu versehen.

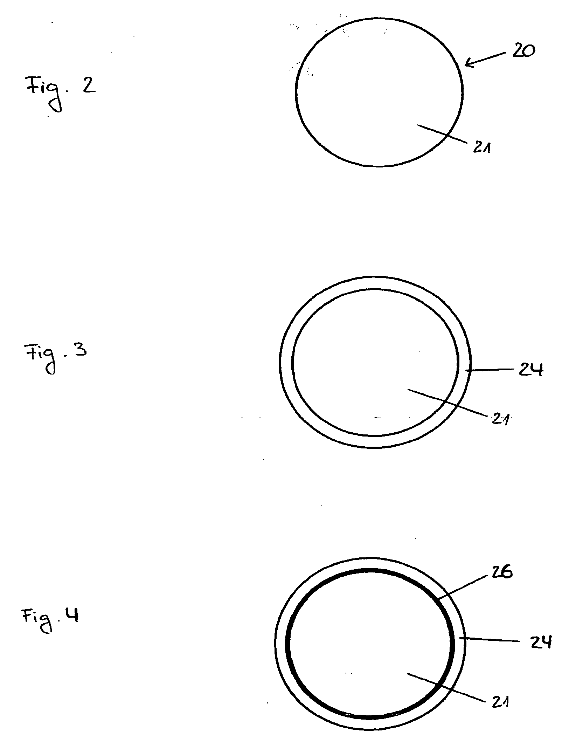

Figur 2 zeigt einen Schnitt durch den Kern 20 eines unbehandelten Ringläufers 10. Der Eisenwerkstoff 21 des Kerns 20 ist vorzugsweise ein unlegierter oder niedrig legierter Kohlenstoffstahl, vorzugsweise ist der Eisenwerkstoff ein unlegierter Werkzeugstahl, Kaltarbeitsstahl oder ein Schnellstahl. Der Kern wird vor kann vor der Beschichtung gehärtet oder ungehärtet sein.

In einer bevorzugten Ausgestaltung wird die Oberfläche des Kerns vor der Beschichtung poliert. Idealerweise wird der Kern vor der Beschichtung zusätzlich entfettet. Dadurch wird eine optimale Schichthaftung der Deckschicht auf dem Kern gewährleistet.

Figur 3 zeigt einen Schnitt durch eine erste Ausführungsform deserfindüngsgemässen Ringläufers, bei dem die Deckschicht unmittelbar auf dem Kern angeordnet ist. Die Ringläufer wird vorzugsweise vollflächig für mit einer Deckschicht 24 beschichtet, obwohl es auch möglich ist, nur die mechanisch und/oder chemisch stark beanspruchten Bereiche mit einer Deckschicht 24 zu versehen. Wie oben unter Figur 1 erwähnt muss insbesondere im Bereich der Lauffläche 1 eine mit 3 bezeichnete Innenseite des Ringläufers 10 verschleissfest und mit guten Gleiteigenschaften ausgestattet sein und daher eine Deckschicht aufweisen. Ebenso kann es vorteilhaft sein die beiden Stirnseiten 2 mit einer Deckschicht 24 zu versehen.

Der erfindungsgemässe Ringläufer wird erhalten, indem der vorzugsweise gehärtete, polierte und entfettete Kern in einer Reaktionskammer auf 700° bis 1200°C erhitzt wird. Dabei reduziert sich die Härte im Kern auf HV 100 - 400. Anschliessend wird gemäss dem CVD Verfahren (chemical vapor deposition) in die Reaktionskammer ein Abscheidungsgas eingeleitet. Falls die Deckschicht Titancarbonitrid enthält wird als Abscheidungsgas CH₃CN und TiCl₄ verwendet. Die Abscheidungsgase, die bei der Herstellung der Chromnitrid-Schicht oder Vanadiumcarbid-Schicht verwendet werden, sind dem Fachmann bekannt. Auf der Oberfläche des Kerns wird dabei eine Schicht mit feinkristallinem Titancarbonitrid, Chromnitrid oder Vanadiumcarbid aufgetragen. Dieses Verfahren kann mehrfach angewendet werden, sodass mehrere Lagen der Deckschicht entstehen. Zwischen dem Aufbringen der einzelnen Lagen der Deckschicht wird der Ringläufer jeweils vorzugsweise gekühlt. Anschliessend wird der beschichtete Ringläufer unter Schutzgas, vorzugsweise unter Stickstoff, während 2 bis 4 Stunden abgekühlt. Die so erhaltene Deckschicht weist eine kristallisierte Nadelstruktur auf. Der so erhaltene Ringläufer wird anschliessend vorzugsweise nachgehärtet, in heissem Öl oder Warmbad abgeschreckt und bei 285°C 1 Stunde angelassen. Schliesslich können die Ringläufer noch poliert werden, um eine fadenfeine Oberfläche zu erhalten.

Figur 4 zeigt einen Schnitt durch eine zweite Ausführungsform des erfindungsgemässen Ringläufers, bei dem zwischen der Deckschicht 24 und dem Kern 20 aus dem Eisenwerkstoff 21 eine Zwischenschicht 26 angeordnet ist. Die Zwischenschicht enthält vorzugsweise TiN. Die Titannitridschicht weist eine ausgesprochen gute Affinität zum Eisenwerkstoff auf, was die Schichthaftung innerhalb des Ringläufers erhöht. Die ca. 0.5 µm dicke Zwischenschicht wird nach dem gleichen Verfahren wie die Deckschicht aufgebracht. Das heisst, der vorzugsweise gehärtete, polierte und entfettete Kern wird in einer Reaktionskammer auf 700° bis 1200°C erhitzt. Anschliessend wird gemäss dem CVD Verfahren (chemical vapor deposition) in die Reaktionskammer ein Abscheidungsgas, eingeleitet. Die Zwischenschicht ist genau wie die Deckschicht vorzugsweise vollflächig auf dem Kern angeordnet, obwohl es auch möglich ist, die Zwischenschicht nur bei dem mechanisch stark beanspruchten Stellen, die oben erwähnt wurden, anzubringen. Nach dem Aufbringen der Zwischenschicht wird die Deckschicht wie oben beschrieben auf den Ringläufer aufgebracht. Der Ringläufer wird nach dem langsamen Abkühlen unter Schutzgas gegebenenfalls nachgehärtet, im Oel oder Warmbad abgeschreckt, angelassen und/oder poliert.

## Patentansprüche

1. Ringläufer (10) für Ringspinn- oder Ringzwirnmaschinen mit einem Kern (20) aus einem Eisenwerkstoff, wobei auf zumindest Teilen des Kerns eine Deckschicht (24) angeordnet ist, **dadurch gekennzeichnet, dass** die Deckschicht Chromnitrid, Vanadiumcarbid oder Titancarbonitrid enthält und eine kristallisierte Nadelstruktur aufweist.

2. Ringläufer (10) gemäss Anspruch 1, **dadurch gekennzeichnet, dass** die Deckschicht (24) Titancarbonitrid enthält.

3. Ringläufer (10) nach einem der vorangehenden Ansprüche, **dadurch gekennzeichnet, dass** die Deckschicht (24) einlagig ist.

4. Ringläufer (10) nach einem der Ansprüche 1 oder 2, **dadurch gekennzeichnet, dass** die Deckschicht (24) mehrlagig ist.

5. Ringläufer (10) nach einem der vorangehenden Ansprüche, **dadurch gekennzeichnet, dass** zwischen der Deckschicht (24) und dem Kern (20) eine Zwischenschicht (26) angeordnet ist, die ausgewählt ist aus der Gruppe von Titannitrid und Chromnitrid.

6. Ringläufer (10) nach einem der vorangehenden Ansprüche, **dadurch gekennzeichnet, dass** die Deckschicht (24) vollflächig auf dem Kern (20) angeordnet ist.

7. Ringläufer (10) nach einem der vorangehenden Ansprüche, **dadurch gekennzeichnet, dass** der Eisenwerkstoff des Kerns (20) ein unlegierter Werkzeugstahl, Kaltarbeitsstahl, ein Federstahl oder ein Schnellstahl ist.

8. Ringläufer (10) nach einem der vorangehenden Ansprüche, **dadurch gekennzeichnet, dass** die Deckschicht 0.1 bis 20 µm dick ist.

9. Ringläufer (10) nach einem der vorangehenden Ansprüche, **dadurch gekennzeichnet, dass** die Deckschicht (24) des Ringläufers poliert ist.

10. Ringläufer (10) nach einem der vorangehenden Ansprüche, **dadurch gekennzeichnet, dass** die Deckschicht (24) eine HV 0.025 von 2600 bis 4000 aufweist.

11. Verfahren zur Herstellung eines Ringläufers (10) mit einem Kern (20) aus Eisenwerkstoff, wobei zumindest Teile des Kerns mit einer Deckschicht (24) enthaltend TiCN, CrN oder VC überzogen werden, in dem
der Kern in einer Reaktionskammer auf 700°C bis 1200°C erhitzt wird,
in die Reaktionskammer ein Abscheidungsgas eingeleitet wird, sodass auf der Oberfläche des Kerns eine Deckschicht (24) angebracht wird, und der beschichtete Ringläufer abgekühlt wird, **dadurch gekennzeichnet, dass** der Ringläufer unter Schutzgas während 2 bis 4 Stunden abgekühlt wird.

12. Verfahren nach Anspruch 9, **dadurch gekennzeichnet, dass** das Abscheidungsgas CH₃CN und TiCl₄ enthält.

13. Verfahren nach einem der Ansprüche 11 bis 12, **dadurch gekennzeichnet, dass** auf dem Kern eine Zwischenschicht aus Titannitrid oder Chromnitrid angeordnet ist.

14. Verfahren nach Anspruch 11, **dadurch gekennzeichnet, dass** der abgekühlte Ringläufer nachgehärtet wird.

15. Verfahren nach Anspruch 14, **dadurch gekennzeichnet, dass** der nachgehärtete Ringläufer in einem Warmbad abgeschreckt und bei einer Temperatur von 200-350°C während 0.5 bis 1.5 Stunden angelassen wird.

## Claims

1. Ring traveller (10) for ring spinning or ring twisting machines, with a core (20) consisting of a ferrous material, wherein a covering layer (24) is arranged on at least parts of the core, **characterized in that** the covering layer contains chromium nitride, vanadium carbide or titanium carbonitride and has a crystallized needle structure.

2. Ring traveller (10) according to Claim 1, **characterized in that** the covering layer (24) contains titanium carbonitride.

3. Ring traveller (10) according to one of the preceding claims, **characterized in that** the covering layer (24) is single-ply.

4. Ring traveller (10) according to either one of Claims 1 and 2, **characterized in that** the covering layer (24) is multi-ply.

5. Ring traveller (10) according to one of the preceding claims, **characterized in that** an intermediate layer (26), which is selected from the group of titanium nitride and chromium nitride, is arranged between the covering layer (24) and the core (20).

6. Ring traveller (10) according to one of the preceding claims, **characterized in that** the covering layer (24) is arranged over the entire area on the core (20).

7. Ring traveller (10) according to one of the preceding claims, **characterized in that** the ferrous material of the core (20) is an unalloyed tool steel, cold work steel, a spring steel or a high-speed steel.

8. Ring traveller (10) according to one of the preceding claims, **characterized in that** the covering layer has a thickness of 0.1 to 20 µm.

9. Ring traveller (10) according to one of the preceding claims, **characterized in that** the covering layer (24) of the ring traveller is polished.

10. Ring traveller (10) according to one of the preceding claims, **characterized in that** the covering layer (24) has an HV 0.025 of 2600 to 4000.

11. Method for producing a ring traveller (10) with a core (20) consisting of ferrous material, wherein at least parts of the core are covered with a covering layer (24) containing TiCN, CrN or VC, in which method
the core is heated to 700°C to 1200°C in a reaction chamber,
a precipitation gas is introduced into the reaction chamber, so that a covering layer (24) is applied to the surface of the core, and the coated ring traveller is cooled, **characterized in that** the ring traveller is cooled under protective gas for 2 to 4 hours.

12. Method according to Claim 9, **characterized in that** the precipitation gas contains CH₃CN and TiCl₄.

13. Method according to either one of Claims 11 and 12, **characterized in that** an intermediate layer consisting of titanium nitride or chromium nitride is arranged on the core.

14. Method according to Claim 11, **characterized in that** the cooled ring traveller is posthardened.

15. Method according to Claim 14, **characterized in that** the posthardened ring traveller is quenched in a hot bath and is tempered at a temperature of 200 - 350°C for 0.5 to 1.5 hours.

## Revendications

1. Curseur (10) pour métiers à filer à anneaux ou métiers à retordre à anneaux, comprenant un noyau (20) constitué d'un matériau ferreux, une couche de recouvrement (24) étant disposée sur au moins certaines parties du noyau, **caractérisé en ce que** la couche de recouvrement contient du nitrure de chrome, du carbure de vanadium ou du carbonitrure de titane et présente une structure d'aiguille cristallisée.

2. Curseur (10) selon la revendication 1, **caractérisé en ce que** la couche de recouvrement (24) contient du carbonitrure de titane.

3. Curseur (10) selon l'une quelconque ou plusieurs des revendications précédentes, **caractérisé en ce que** la couche de recouvrement (24) est monocouche.

4. Curseur (10) selon l'une quelconque des revendications 1 ou 2, **caractérisé en ce que** la couche de recouvrement (24) est multicouche.

5. Curseur (10) selon l'une quelconque des revendications précédentes, **caractérisé en ce qu'**une couche intermédiaire (26) est disposée entre la couche de recouvrement (24) et le noyau (20), laquelle est choisie à partir du groupe du nitrure de titane et du nitrure de chrome.

6. Curseur (10) selon l'une quelconque des revendications précédentes, **caractérisé en ce que** la couche de recouvrement (24) est disposée sur toute sa surface sur le noyau (20).

7. Curseur (10) selon l'une quelconque des revendications précédentes, **caractérisé en ce que** le matériau ferreux du noyau (20) est un acier à outils non allié, un acier pour le travail à froid, un acier à ressort ou un acier rapide.

8. Curseur (10) selon l'une quelconque des revendications précédentes, **caractérisé en ce que** la couche de recouvrement a une épaisseur de 0,1 à 20 µm.

9. Curseur (10) selon l'une quelconque des revendications précédentes, **caractérisé en ce que** la couche de recouvrement (24) du curseur est polie.

10. Curseur (10) selon l'une quelconque des revendications précédentes, **caractérisé en ce que** la couche de recouvrement (24) présente un indice de dureté Vickers 0,025 de 2600 à 4000.

11. Procédé de fabrication d'un curseur (10) comprenant un noyau (20) en matériau ferreux, au moins certaines parties du noyau étant revêtues d'une couche de recouvrement (24) contenant du TiCN, du CrN, ou du VC,
le noyau étant chauffé dans une chambre de réaction à 700°C à 1200°C,
dans la chambre de réaction, un gaz de séparation étant introduit, de telle sorte qu'une couche de recouvrement (24) soit appliquée sur la surface du noyau, et le curseur revêtu étant refroidi,
**caractérisé en ce que** le curseur est refroidi pendant 2 à 4 heures sous un gaz protecteur.

12. Procédé selon la revendication 9, **caractérisé en ce que** le gaz de séparation contient du CH₃CN et du TiCl₄.

13. Procédé selon l'une quelconque des revendications 11 à 12, **caractérisé en ce qu'**une couche intermédiaire de nitrure de titane ou de nitrure de chrome est disposée sur le noyau.

14. Procédé selon la revendication 11, **caractérisé en ce que** le curseur refroidi est post-durci.

15. Procédé selon la revendication 14, **caractérisé en ce que** le curseur post-durci est trempé dans un bain chaud et est revenu à une température de 200 à 350°C pendant 0,5 à 1,5 heure.
